# EUROPEAN PATENT SPECIFICATION

(11) **EP 0 862 356 B1**
(45) Date of publication and mention of the grant of the patent: **29.05.2002**
(21) Application number: 98103383.0
(22) Date of filing: 26.02.1998
(51) Int. Cl.: H05K 13/04, H05K 13/02

(54) **Electronic component-mounting apparatus**
Einrichtung zur Montage von elektronischen Bauteilen
Appareil de montage de composant électronique

(30) Priority: 28.02.1997 JP 6195097
(43) Date of publication of application: 02.09.1998
(73) Proprietor: SANYO ELECTRIC CO. LTD, Moriguchi-shi, Osaka-fu (JP)
(72) Inventor: Seto, Katsuyuki, Ota-shi, Gunma-ken (JP); Fukushima, Yoshiharu, Ora-gun, Gunma-ken (JP)
(74) Representative: Glawe, Delfs, Moll & Partner

(56) References cited:
- JP-A- 8 162 797
- US-A- 5 153 983

## Description

### BACKGROUND OF THE INVENTION

### Field of the Invention

This invention relates to an electronic component-mounting apparatus of a multi-function type for mounting various types of supplied electronic components, on a circuit board.

### Prior Art

Conventionally, an electronic component-mounting apparatus of the above-mentioned kind has been proposed e.g. by Japanese Laid-Open Patent Publication (Kokai) No. 4-35095, in which a plurality of types of electronic components are directly fed to a pickup area of a main block of the apparatus via a plurality of tape feeders arranged in parallel with each other. Further, another electronic component-mounting apparatus has been proposed by US-A-5 153 983, in which a component feeder of a tray type for feeding electronic components of QFP (Quad Flat Package) type or the like in a tray is provided in combination with the tape feeders. More specifically, in this electronic component-mounting apparatus, a component feeder of a tape type and a component feeder of a tray type are arranged, side by side, on one side of a main block of the apparatus parallel to a transfer passage for transferring circuit boards whereby various types of electronic components are directly fed to a pickup area of the main block of the apparatus. Further, this kind of electronic component-mounting apparatus has its main block housed within a cabinet for safety reasons which has inspecting openings formed through a front side and a rear side thereof, respectively, for use in maintenance operations, the front side being on the same side as the above-mentioned one side of the main part of the apparatus.

The proposed electronic component-mounting apparatus thus constructed, however, suffers from the following problem: The component feeder of a tape type and that of a tray type are arranged side by side on the one side of the main block parallel to the transfer passage, whereby the pickup area can be designed relatively narrow. However, so long the component feeder of a tape type is concerned, since the number types of electronic components is limited by the number of tape feeders which can be arranged, the number of types of electronic components which can be directly fed is decreased due to provision of the component feeder of a tray type to the main block. Further, since the component feeder of a tape type and that of a tray type are arranged side by side in a manner facing one of the inspecting openings, the component feeder of a tray type, which is the taller of the two, makes it difficult to perform maintenance operations on the main block.

### SUMMARY OF THE INVENTION

It is the object of the invention to provide an electronic component-mounting apparatus which is improved in ease of maintenance of a main block of the apparatus and capable of directly feeding an increased number of types of electronic component parts to the main block.

To attain the above object, the invention provides an electronic component-mounting apparatus for mounting electronic components on a circuit board, comprising:
a transfer passage for transferring the circuit board therealong;
a main block for carrying out mounting of the electronic component parts, the main block having a first side parallel to the transfer passage, a second side perpendicular to the first side, and a pickup area to which the electronic components are supplied for being picked up;
a first electronic component-feeding block arranged on the first side, the first electronic component-feeding block including a plurality of feeders arranged in parallel with each other for directly feeding a plurality of types of electronic components, respectively, to the pickup area; and
a second electronic component-feeding block arranged on the second side, the second electronic component-feeding block including a plurality of trays each carrying a number of electronic components thereon, and selectively bringing the plurality of trays to the pickup area to thereby supply a plurality of types of electronic components to the pickup area.

According to this electronic component-mounting apparatus, the first electronic component-feeding block is arranged on the first side of the main block parallel to the transfer passage, while the second electronic component-feeding block is arranged on the second side of the main block perpendicular to the first side. Therefore, it is possible to arrange in the first electronic component-feeding block as many tape feeders as corresponding to the length of the first side of the main block, in parallel with each other. That is, it is possible to increase the number of types of electronic components which can be directly fed from the first electronic component-feeding block. Further, according to a preferred embodiment of the invention the second electronic component-feeding block is arranged at a location away from an inspecting opening of the main block which is usually provided on the first side of the main block of the apparatus, so that maintenance operations on the main block are not obstructed by the second electronic component-feeding block and there is no need to design the second electronic component-feeding block low for maintenance purposes. Moreover, a direction of feeding of electronic components from the first electronic component-feeding block and a direction of feeding of electronic components from the second electronic component-feeding block are perpendicular to each other. Therefore, it is possible to form the pickup area relatively narrow.

Preferably, the second side comprises two opposite sides of the main block, the second electronic component-feeding block comprises two component feeders arranged on the two opposite sides, respectively.

According to this preferred embodiment, it is possible to increase the number of types of electronic components which can be directly fed from the second electronic component-feeding block without degrading the above-mentioned maintenance characteristics or ease of maintenance of the main block and without widening the pickup area. Further, if electronic components (trays) are fed to the main block alternately by the two component feeders, it possible to eliminate time losses wasted for feeding electronic components.

Preferably, the second electronic component-feeding block comprises a component saving block for holding in stock a large number of pallets on which a large number of trays are placed, a pallet feeder for selectively feeding pallets supplied from the component saving block, to the pickup area, and a pallet transfer device for selectively transferring the large number of pallets between the component saving block and the pallet feeder.

More preferably, the pallet feeder comprises a pallet-receiving case for receiving a plurality of pallets in a manner vertically arranged therein, and a lift mechanism for lifting and lowering the pallet-receiving case to thereby bring a selected one of the plurality of pallets received in the pallet-receiving case to a level suitable for sending the selected one of the plurality of pallets into and out of the pallet-receiving case.

Further preferably, the electronic component-mounting apparatus includes a pallet guide mechanism for guiding a selected one of the plurality of pallets received in the pallet-receiving case to the pickup area.

Still more preferably, the electronic component-mounting apparatus includes a control block for controlling the pallet transfer device, the lift mechanism of the pallet feeder, and the pallet guide mechanism, to thereby cause the pallet transfer device, the lift mechanism of the pallet feeder, and the pallet guide mechanism, to operate in an .interlocked manner.

For example, the feeders of the first electronic component-feeding block are tape feeders.

The above and other objects, features, and advantages of the invention will become more apparent from the following detailed description taken in conjunction with the accompanying drawings.

### BRIEF DESCRIPTION OF THE DRAWINGS

FIG. 1 is a plan view of an electronic component-mounting apparatus having component feeders mounted thereon, according to an embodiment of the invention; and
FIG. 2 is a side view of a second component feeder according to the embodiment.

### DETAILED DESCRIPTION

The invention will now be described in detail with reference to the drawings showing an embodiment thereof.

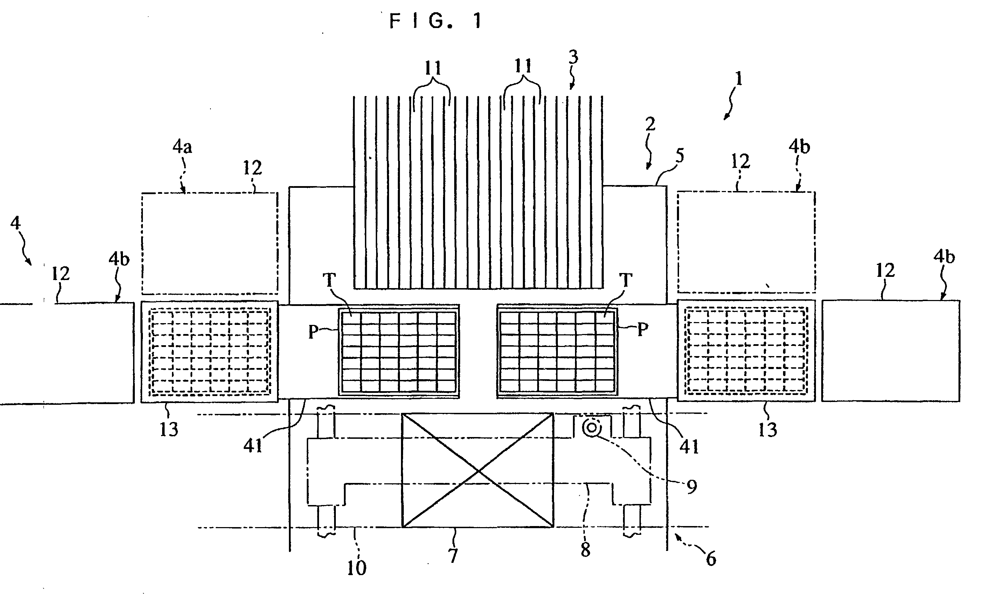

Referring first to FIG. 1, there is shown an electronic component-mounting apparatus according to the embodiment of the invention, which is a so-called multi-function chip mounter used for mounting various types of electronic components , such as surface mount components including chip capacitors, chip resistances, etc., and multi-lead components of flat package ICs. The electronic component-mounting apparatus 1 is comprised of a main block 2 for mounting supplied electronic components on a circuit board, a first electronic component feeder (first electronic component-feeding block) 3 for feeding small-sized electronic components, such as surface mount components, to the main block 2, a second electronic component feeder (second electronic component-feeding block) 4 for feeding large-sized electronic components, such as multi-lead components, to the main block 2.

The main block 2 includes a base 5, a circuit board transfer device 6 having a table 7 arranged at a central portion of the base 5, and an X-Y stage 8 having one or two mounting heads 9 installed thereon. The mounting head 9 is brought to the first electronic component feeder 3 or the second electronic component feeder 4 by operation of the X-Y stage to pick up an electronic component, and then mounts the electronic component on the circuit board set on the table 7. When the above operation is repeatedly carried out to complete the mounting of the electronic components on the circuit board, the circuit board transfer device 6 sends forward the circuit board along a transfer passage 10 for conveying circuit boards, and thereafter a new circuit board is set on the table 7 in place of the delivered circuit board.

The first electronic component feeder 3 is comprised of a lot of cassette-type tape feeders 11 arranged in parallel with each other on one side of the base 5, which is parallel to the.transfer passage 10, such that each tape feeder 11 has a front end thereof facing a pickup area at which the mounting head 9 picks up electronic components. Electronic components are contained in each tape feeder 11 in a state loaded in a carrier tape, not shown, to be fed from the front end of the tape feeder 11 one by one.

In the present embodiment, the first electronic component feeder 3 is removably arranged on the base 5 and each tape feeder 11 is detachably arranged on the first electronic component feeder 3. The main block 2 is housed within a cabinet, not shown, and a portion of the cabinet at which the first electronic component feeder 3 is arranged is formed with a wide inspecting opening. Maintenance operations on the main block are performed through this inspecting opening, in a state in which the first electronic component feeder 3 is detached from or mounted on the base.

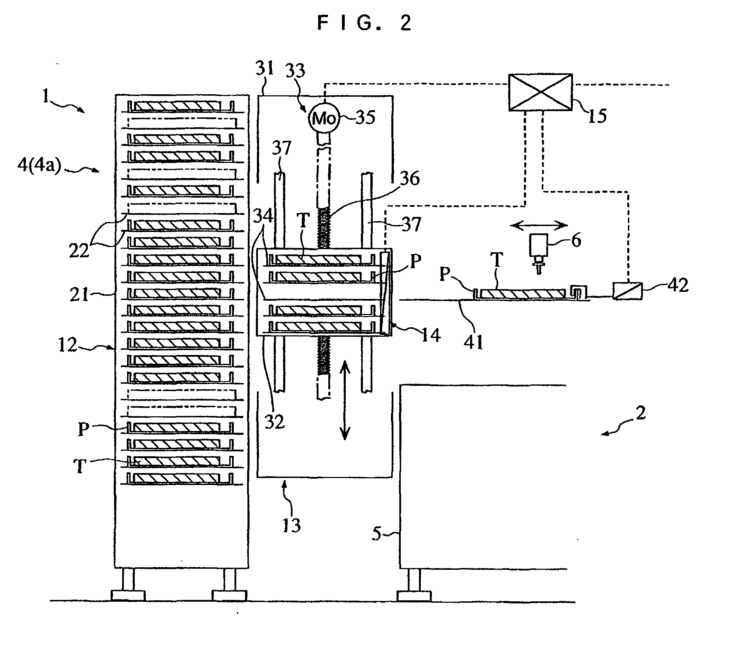

Next, the second electronic component feeder 4 will be described with reference to FIGS. 1 and 2. The second component feeder is comprised of a left-hand component feeder 4a on a left-hand side of the base 5 and a right-hand component feeder 4b on a right-hand side of the base 5, as viewed in FIG. 1, arranged at respective locations symmetric with respect to the base 5. That is, the left-hand and right-hand component feeders 4a, 4b are each arranged on a side perpendicular to the side of the base 5 on which the first electronic component feeder 3 is arranged. In each of the left-hand and right-hand component feeders 4a, 4b, a large number of electronic components are placed in a state aligned with each other on trays T. Further, one or a plurality of trays T are placed on each pallet P which is brought to a pickup position located between the first electronic component feeder 3 and the table 7 to thereby feed electronic components to the main block 2.

It should be noted that the left-hand component feeder 4a and the right-hand component feeder 4b have an identical construction, so that hereafter only the left-hand component feeder 4a will be described and description of the right-hand component feeder 4b will be omitted.

The left-hand component feeder 4a is comprised of a pallet storage device 12 for holding a large number of pallets P in stock, a pallet feeder 13 for bringing a desired pallet P to the main block 2, and a pallet transfer device 14 for selectively carrying pallets P between the pallet storage device 12 and the pallet feeder 13. The pallet storage device 12 is comprised of a cabinet 21, and a lot of shelves 22 arranged within the cabinet 21 in a vertically-spaced manner for placing pallets P thereon. The cabinet 21 has a wide opening formed on a side facing toward the pallet feeder 13, via which the pallets P are selectively moved in and out. It should be noted that the pallet storage device 12 is not necessarily arranged at a location outward of the pallet feeder 13 with respect to the main block 2, as indicated by the solid lines in Fig. 1, but it may be arranged at a location which corresponds to a portion extended from the first electronic component feeder 3 in a direction parallel to the transfer passage 10 (and at the same time on the side perpendicular to the side of the base 5 on which the first electronic component feeder 3 is arranged), as indicated by phantom lines in the figure, and further may be provided at both of these locations.

The pallet feeder 13 has a cabinet 31 incorporating a pallet-receiving case 32 for receiving a plurality of pallets P therein and a lift mechanism 33 for lifting and lowering the pallet-receiving casing 32. In the pallet-receiving case 32, there are a plurality of shelves 34 arranged in a vertically-spaced manner for placing pallets P thereon. Further, the pallet-receiving case 32 is open on a side facing toward the pallet storage device 12 and on a side facing toward the main block 2, which makes it possible to carry (transfer) pallets P between the pallet-receiving case 32 and the pallet storage device 12, and between the pallet-receiving case 32 and the main block 2.

The lift mechanism 33 is comprised e.g. of a drive motor 35, a ball screw 36 having a root side thereof connected to the drive motor 35 and extending perpendicularly, and a pair of guide rails 37, 37 for guiding the pallet-receiving case 32 when it is lifted and lowered. The ball screw 36 is screwed into an internal thread, not shown, formed through the pallet-receiving case 32. This ball screw 36 is rotated in a normal or reverse direction by the drive motor 35, whereby the pallet-receiving case 32 is guided upward and downward by the guide rails 37, 37. The upward or downward movement of the pallet-receiving case 32 is controlled by a controller 15 connected to the drive motor 35. When a pallet P is to be carried into and out of the pallet-receiving case 32, the controller 15 lifts and lowers the pallet-receiving case 32 to bring a desired shelf 34 within the pallet-receiving case 32 to the same level as a desired shelf 22 in the pallet storage device 12 or as a pallet guide passage 41 in the main block 2.

The pallet transfer device 14, which is incorporated e.g. in the above pallet-receiving case 32, is comprised of a hook for engagement with or disengagement from any of the pallets P, a mechanism, such as a linkage and gear wheels, for moving a selected pallet P forward and backward between the pallet-receiving case 32 and the pallet storage device 12 by the above hook, and a motor for driving the mechanism, or alternatively the pallet transfer device 14 is of a conveyor type. The motor of the pallet transfer device 14 is also connected to the above controller 15 which not only controls the transfer of pallets P but also causes the above-mentioned lift mechanism 33 and the pallet transfer device 14 to operate in an interlocked manner, as required.

The main block 2 is provided with a pallet guide device 42 which draws out a pallet P from the pallet-receiving case 32, and guides the same along a pallet guide passage 41, to thereby bring the pallet P to the pickup position of the main block 2. The pallet guide device 42 is also connected to the above controller 15 to be operated in a manner interlocked to the pallet feeder 13.

The basic operations performed by the left-hand component feeder 4a are to hold in the pallet storage device 12 a large number of pallets P for feeding component parts to a plurality of types of circuit boards, and to transfer only a plurality of pallets P which are suitable for feeding component parts to specific circuit boards (of a single type) on which the component parts are to start to be mounted, from the pallet storage device 12 to the pallet feeder 13 to thereby feed electronic components from the pallet feeder 13 to the main block 2 by the pallets P. Further, when the operation of the apparatus is changed for mounting of component parts on circuit boards of a different type, the main block 2 temporarily stops its mounting operation and during a time period of this temporary stop of mounting operation, pallets P in the pallet-receiving case 32 are replaced by selected ones obtained from the pallet storage device 12.

As described above, according to the present embodiment, the first electronic component feeder 3 is arranged on one side of the main block (base 5) 2 parallel to the transfer passage 10, while the left-hand and right-hand component feeders 4a, 4b of the second electronic component feeder 4 are arranged on opposite sides of the main block (base 5) 2 perpendicular to the one side of the main block on which the first electronic component feeder 3 is arranged. Therefore, it is possible to arrange as many tape feeders 11 as possible on the above-mentioned side of the base 5. That is, apart from the component feeders 4a, 4b, types of electronic components (at the same time the number of the component parts) which can be fed by the first electronic component feeder 3 can be increased in number. Further, the component feeders 4a, 4b are arranged at locations deviated from the inspecting opening of the main block 2, so that maintenance operations on the main block are not obstructed by the second component feeders, which improves ease of maintenance of the main block of the apparatus.

Further, even if the first electronic component feeder 3 becomes larger in size, the pickup areas of the first electronic component feeder 3 and the left-hand and right-hand component feeders 4a, 4b of the second electronic component feeder 4 do not become excessively wider than those of the conventional component feeders and hence the tact time of mounting electronic components on the circuit boards is not adversely affected. Inversely, the second electronic component feeder 4 is comprised of the left-hand component feeder 4a and the right-hand component feeder 4b to thereby eliminate time losses wasted for guiding pallets P, which makes it possible to reduce the tact time of the whole process carried out by the electronic component-mounting apparatus. Alternatively, two mounting heads 9 may be mounted on the X-Y stage 8 so as to enable the two mounting heads to pick up electronic components from the left-hand component feeder 4a and the right-hand component feeder 4b, respectively.

The second electronic component feeder 4 may be formed of a single device formed of either the left-hand component feeder or the right-hand component feeder. Further, the first electronic component feeder 3 may be formed by stick feeders instead of the tape feeders 11 or may be formed by a combination of the two types of the feeders.

As described above, according to the electronic component-mounting apparatus of the invention, the first electronic component-feeding block and the second electronic component-feeding block are arranged on different sides of the main block, so that even if the second electronic component-feeding block taller than the first electronic component-feeding block is constructed, maintenance operations are not obstructed, and further it is possible to increase the number of types of electronic component parts which can be directly fed to the main block from both the first electronic component-feeding block and the second electronic component-feeding block. This makes it possible to improve ease of maintenance of the main block, and simplify operations to be carried out by workers.

## Claims

1. An electronic component-mounting apparatus for mounting electronic components on a circuit board, comprising:
a transfer passage (10) for transferring said circuit board therealong;
a main block (2) for carrying out mounting of said electronic component parts, said main block having a first side parallel to said transfer passage, a second side perpendicular to said first side, and a pickup area to which said electronic components are supplied for being picked up;
a first electronic component-feeding block (3) arranged on said first side, said first electronic component-feeding block including a plurality of feeders (11) arranged in parallel with each other for directly feeding a plurality of types of electronic components, respectively, to said pickup area; and
a second electronic component-feeding block (4a, 4b) arranged on said second side, said second electronic component-feeding block including a plurality of trays (T) each carrying a number of electronic components thereon, and selectively bringing said plurality of trays to said pickup area to thereby supply a plurality of types of electronic components to said pickup area.

2. An electronic component-mounting apparatus according to claim 1, wherein said second side comprises two opposite sides of said main block, said second electronic component-feeding block comprises two component feeders arranged on said two opposite sides, respectively.

3. An electronic component-mounting apparatus according to claim 1, wherein said second electronic component-feeding block comprises a component saving block for holding in stock a large number of pallets on which a large number of trays are placed, a pallet feeder for selectively feeding pallets supplied from said component saving block, to said pickup area, and a pallet transfer device for selectively transferring said large number of pallets between said component saving block and said pallet feeder.

4. An electronic component-mounting apparatus according to claim 2, wherein said second electronic component-feeding block comprises a component saving block for holding in stock a large number of pallets on which a large number of trays are placed, a pallet feeder for selectively feeding pallets supplied from said component saving block, to said pickup area, and a pallet transfer device for selectively transferring said large number of pallets between said component saving block and said pallet feeder.

5. An electronic component-mounting apparatus according to claim 3, wherein said pallet feeder comprises a pallet-receiving case for receiving a plurality of pallets in a manner vertically arranged therein, and a lift mechanism for lifting and lowering said pallet-receiving case to thereby bring a selected one of said plurality of pallets received in said pallet-receiving case to a level suitable for sending said selected one of said plurality of pallets into and out of said pallet-receiving case.

6. An electronic component-mounting apparatus according to claim 4, wherein said pallet feeder comprises a pallet-receiving case for receiving a plurality of pallets in a manner vertically arranged therein, and a lift mechanism for lifting and lowering said pallet-receiving case to thereby bring a selected one of said plurality of pallets received in said pallet-receiving case to a level suitable for sending said selected one of said plurality of pallets into and out of said pallet-receiving case.

7. An electronic component-mounting apparatus according to claim 5, including a pallet guide mechanism for guiding a selected one of said plurality of pallets received in said pallet-receiving case to said pickup area.

8. An electronic component-mounting apparatus according to claim 6, including a pallet guide mechanism for guiding a selected one of said plurality of pallets received in said pallet-receiving case to said pickup area.

9. An electronic component-mounting apparatus according to claim 7, including a control block for controlling said pallet transfer device, said lift mechanism of said pallet feeder, and said pallet guide mechanism, to thereby cause said pallet transfer device, said lift mechanism of said pallet feeder, and said pallet guide mechanism, to operate in an interlocked manner.

10. An electronic component-mounting apparatus according to claim 8, including a control block for controlling said pallet transfer device, said lift mechanism of said pallet feeder, and said pallet guide mechanism, to thereby cause said pallet transfer device, said lift mechanism of said pallet feeder, and said pallet guide mechanism, to operate in an interlocked manner.

11. An electronic component-mounting apparatus according to claim 1, wherein said feeders of said first electronic component-feeding block are tape feeders.

## Patentansprüche

1. Elektronikbauteil-Montagevorrichtung zum Montieren elektronischer Bauteile auf einer Leiterplatte, welche aufweist:
eine Überführungspassage (10) zum Überführen der Leiterplatte an ihr entlang;
einen Hauptblock (2) zum Durchführen des Montierens der elektronischen Bauteile, wobei der Hauptblock eine zu der Überführungspassage parallele erste Seite hat, eine zu der ersten Seite senkrechte zweite Seite hat und einen Aufnahmebereich hat, dem die elektronischen Bauteile zugeführt werden, um aufgenommen zu werden;
einen an der ersten Seite angeordneten ersten Elektronikbauteil-Zuführblock (3), wobei der erste Elektronikbauteil-Zuführblock eine Vielzahl von Fördereinrichtungen (11) enthält, die parallel zueinander angeordnet sind, um eine Vielzahl von Arten elektronischer Bauteile jeweils unmittelbar dem Aufnahmebereich zuzuführen; und
einen an der zweiten Seite angeordneten zweiten Elektronikbauteil-Zuführblock (4a, 4b), wobei der zweite Elektronikbauteil-Zuführblock eine Vielzahl von Schalen (T) enthält, die jeweils eine Anzahl elektronischer Bauteile darauf tragen, wobei die Vielzahl der Schalen selektiv zu dem Aufnahmebereich gebracht werden, um dadurch eine Vielzahl von Arten elektronischer Bauteile dem Aufnahmebereich zuzuführen.

2. Elektronikbauteil-Montagevorrichtung nach Anspruch 1, **dadurch gekennzeichnet, daß** die zweite Seite zwei entgegengesetzte Seiten des Hauptblocks aufweist, wobei der zweite Elektronikbauteil-Zuführblock zwei Bauteil-Fördervorrichtungen aufweist, die jeweils an den beiden entgegengesetzten Seiten angeordnet sind.

3. Elektronikbauteil-Montagevorrichtung nach Anspruch 1, **dadurch gekennzeichnet, daß** der zweite Elektronikbauteil-Zuführblock aufweist: einen Bauteil-Vorratsblock zum Aufbewahren einer großen Anzahl von Paletten, auf denen eine große Anzahl von Schalen abgestellt werden; eine Paletten-Fördervorrichtung zum selektiven Fördern von Paletten, die von dem Bauteil-Vorratsblock zugeführt werden, zu dem Aufnahmebereich; und eine Paletten-Überführungsvorrichtung zum selektiven Überführen der großen Anzahl von Paletten zwischen dem Bauteil-Vorratsblock und der Paletten-Fördervorrichtung.

4. Elektronikbauteil-Montagevorrichtung nach Anspruch 2, **dadurch gekennzeichnet, daß** der zweite Elektronikbauteil-Zuführblock aufweist: einen Bauteil-Vorratsblock zum Aufbewahren einer großen Anzahl von Paletten, auf denen eine große Anzahl von Schalen abgestellt werden; eine Paletten-Fördervorrichtung zum selektiven Fördern von Paletten, die von dem Bauteil-Vorratsblock zugeführt werden, zu dem Aufnahmebereich; und eine Paletten-Überführungsvorrichtung zum selektiven Überführen der großen Anzahl von Paletten zwischen dem Bauteil-Vorratsblock und der Paletten-Fördervorrichtung.

5. Elektronikbauteil-Montagevorrichtung nach Anspruch 3, **dadurch gekennzeichnet, daß** die Paletten-Fördervorrichtung aufweist: einen Paletten-Aufnahmekasten zum Aufnehmen einer Vielzahl von Paletten, die in ihm vertikal angeordnet sind; und einen Hebemechanismus zum Heben und Absenken des Paletten-Aufnahmekastens, um dadurch eine ausgewählte Palette der Vielzahl von Paletten, die in dem Paletten-Aufnahmekasten enthalten sind, auf eine geeignete Höhe zu bringen, um die ausgewählte Palette der Vielzahl von Paletten in den Paletten-Aufnahmekasten hinein und aus ihm heraus zu senden.

6. Elektronikbauteil-Montagevorrichtung nach Anspruch 4, **dadurch gekennzeichnet, daß** die Paletten-Fördervorrichtung aufweist: einen Paletten-Aufnahmekasten zum Aufnehmen einer Vielzahl von Paletten, die in ihm vertikal angeordnet sind; und einen Hebemechanismus zum Heben und Absenken des Paletten-Aufnahmekastens, um dadurch eine ausgewählte Palette der Vielzahl von Paletten, die in dem Paletten-Aufnahmekasten enthalten sind, auf eine geeignete Höhe zu bringen, um die ausgewählte Palette der Vielzahl von Paletten in den Paletten-Aufnahmekasten hinein und aus ihm heraus zu senden.

7. Elektronikbauteil-Montagevorrichtung nach Anspruch 5, welche einen Paletten-Führungsmechanismus enthält, um eine ausgewählte Palette der Vielzahl von Paletten, die in dem Paletten-Aufnahmekasten enthalten sind, zu dem Aufnahmebereich zu führen.

8. Elektronikbauteil-Montagevorrichtung nach Anspruch 6, welche einen Paletten-Führungsmechanismus enthält, um eine ausgewählte Palette der Vielzahl von Paletten, die in dem Paletten-Aufnahmekasten enthalten sind, zu dem Aufnahmebereich zu führen.

9. Elektronikbauteil-Montagevorrichtung nach Anspruch 7, welche einen Steuerungsblock enthält, um die Paletten-Überführungsvorrichtung, den Hebemechanismus der Palettenüberführungsvorrichtung und den Paletten-Führungsmechanismus zu steuern, um dadurch zu bewirken, daß die Paletten-Überführungsvorrichtung, der Hebemechanismus der Paletten-Fördervorrichtung und der Paletten-Führungsmechanismus ineinandergreifend arbeiten.

10. Elektronikbauteil-Montagevorrichtung nach Anspruch 8, welche einen Steuerungsblock enthält, um die Paletten-Überführungsvorrichtung, den Hebemechanismus der Paletten-Fördervorrichung und den Paletten-Führungsmechanismus zu steuern, um dadurch zu bewirken, daß die Paletten-Überführungsvorrichtung, der Hebemechanismus der Paletten-Fördervorrichtung und der Paletten-Führungsmechanismus ineinandergreifend arbeiten.

11. Elektronikbauteil-Montagevorrichung nach Anspruch 1, bei der die Fördervorrichtungen des ersten Elektronikbauteil-Zuführblocks Bandförderer sind.

## Revendications

1. Appareil de montage de composant électronique pour monter des composants électroniques sur une carte de circuit, comprenant:
un passage de transfert (10) pour transférer ladite carte de circuit le long de celui-ci;
un block principal (2) pour effectuer ledit montage desdits parts de composant électronique, ledit block principal ayant un premier côté parallèle audit passage de transfert, un second côté perpendiculaire audit premier côté, et une région de ramassage à laquelle lesdits composants électronique sont fournies afin d'être ramassées;
un premier block d'amenée de composant électronique (3) disposé sur ledit premier côté, ledit premier block d'amenée de composant électronique comportant une pluralité de dispositifs d'amenée (11) disposés en parallèle les uns aux autres pour amener directement une pluralité de types de composants électroniques respectivement à ladite région de ramassage; et
un second block d'amenée de composant électronique (4a, 4b) disposé sur ledit second côté, ledit second block d'amenée de composant électronique comportant une pluralité de plateaux (T) dont chacun porte un nombre de composants électroniques, ladite pluralité de plateaux étant amenée sélectivement à ladite région de ramassage pour ainsi fournir une pluralité de types de composants électroniques à ladite région de ramassage.

2. Appareil de montage de composant électronique selon la revendication 1, **caractérisé en ce que** ledit second côté comprend deux côtés opposés dudit block principal, ledit second block d'amenée de composant électronique comprenant deux dispositifs d'amenée de composants disposés respectivement sur lesdits deux côtés opposés.

3. Appareil de montage de composant électronique selon la revendication 1, **caractérisé en ce que** ledit second block d'amenée de composant électronique comprend un block de stockage de composant pour maintenir en stock un nombre important de pallettes sur lesquelles un nombre important de plateaux sont placés, un dispositif d'amenée de plateaux pour amener sélectivement des pallettes fournies dudit block de stockage de composant à ladite région de ramassage, et un dispositif de transfert de pallette pour tranférer sélectivement ledit nombre important de pallettes entre ledit block de stockage de composant et ledit dispositif d'amenée de pallettes.

4. Appareil de montage de composant électronique selon la revendication 2, **caractérisé en ce que** ledit second block d'amenée de composant électronique comprend un block de stockage de composant pour maintenir en stock un nombre important de pallettes sur lesquelles un nombre important de plateaux sont placés, un dispositif d'amenée de plateaux pour amener sélectivement des pallettes fournies dudit block de stockage de composant à ladite région de ramassage, et un dispositif de transfert de pallette pour tranférer sélectivement ledit nombre important de pallettes entre ledit block de stockage de composant et ledit dispositif d'amenée de pallettes.

5. Appareil de montage de composant électronique selon la revendication 3, **caractérisé en ce que** ledit dispositif d'amenée de pallette comprend une boîte de réception de pallette pour recevoir une pluralité de pallettes disposées de manière verticale dans cette dernière, et un mécanisme de levage pour lever et abaisser ladite boîte de réception de pallette pour ainsi amener une pallette sélectionnée de ladite pluralité de pallettes reçues dans ladite boîte de réception de pallette à un niveau utile pour envoyer ladite pallette sélectionnée de ladite pluralité de pallettes vers l'intérieur et vers l'extérieur de ladite boîte de réception de pallette.

6. Appareil de montage de composant électronique selon la revendication 4, **caractérisé en ce que** ledit dispositif d'amenée de pallette comprend une boîte de réception de pallette pour recevoir une pluralité de pallettes disposées de manière verticale dans cette dernière, et un mécanisme de levage pour lever et abaisser ladite boîte de réception de pallette pour ainsi amener une pallette sélectionnée de ladite pluralité de pallettes reçues dans ladite boîte de réception de pallette à un niveau utile pour envoyer ladite pallette sélectionnée de ladite pluralité de pallettes vers l'intérieur et vers l'extérieur de ladite boîte de réception de pallette.

7. Appareil de montage de composant électronique selon la revendication 5, comprenant un mécanisme de guidage de pallette pour guider une pallette sélectionnée de ladite pluralité de pallettes reçues dans ladite boîte de réception de pallette vers ladite région de ramassage.

8. Appareil de montage de composant électronique selon la revendication 6, comprenant un mécanisme de guidage de pallette pour guider une pallette sélectionnée de ladite pluralité de pallettes reçues dans ladite boîte de réception de pallette vers ladite région de ramassage.

9. Appareil de montage de composant électronique selon la revendication 7, comprenant un block de commande pour commander ledit dispositif de transfert de pallette, ledit mécanisme de levage dudit dispositif d'amenée de pallette, et ledit mécanisme de guidage de pallette pour ainsi provoquer un fonctionnement verrouillé dudit dispositif de transfert de pallette, dudit mécanisme de levage dudit dispositif d'amenée de pallette, et dudit mécanisme de guidage de pallette.

10. Appareil de montage de composant électronique selon la revendication 8, comprenant un block de commande pour commander ledit dispositif de transfert de pallette, ledit mécanisme de levage dudit dispositif d'amenée de pallette, et ledit mécanisme de guidage de pallette pour ainsi provoquer un fonctionnement verrouillé dudit dispositif de transfert de pallette, dudit mécanisme de levage dudit dispositif d'amenée de pallette, et dudit mécanisme de guidage de pallette.

11. Appareil de montage de composant électronique selon la revendication 1, dans lequel lesdits dispositifs d'amenée dudit premier block d'amenée de composant électronique sont des dispositif d'amenée à bande.
